# EUROPEAN PATENT APPLICATION

(11) **EP 4 614 815 A1**
(43) Date of publication of application: **10.09.2025**
(21) Application number: 24161382.7
(22) Date of filing: 05.03.2024
(51) Int. Cl.: H03K 17/06, H03K 17/0812, H03K 17/08

(54) **OVER VOLTAGE PROTECTION OF HIGH SPEED DIGITAL SIGNAL LINES**

(71) Applicant: Airbus Defence and Space GmbH, 82024 Taufkirchen (DE)
(72) Inventor: Strixner, Erich, 82024 Taufkirchen (DE)
(74) Representative: Frenkel, Matthias Alexander

(57) **Abstract**

The invention relates to an over-voltage-protection-circuit 100 that is configured to protect a high-speed digital signal driver (200) against a positive and negative over voltage injection from an application hardware (210). An embodiment of an over-voltage-protection-circuit 100 comprises:
a first semiconductor switch (400) that is configured to short a fault current (231) in the event of an over voltage injection; and
an input-circuit-element (300) that is configured to reduce the fault current (231) in the event of an over voltage injection; and
a power supply (430) that is connected to a control input of the first semiconductor switch and that is configured to switch the first semiconductor switch (400) in the event of an over voltage injection and to be inactive in a normal operating mode.

## Description

The invention relates to an over-voltage-protection circuit for high-speed digital signal lines.

High-speed digital signal lines are commonly used for high-speed data transmission in applications such as liquid crystal display television (LCD-TV), industrial cameras or in-car entertainment. A common example of high-speed digital signal lines is the Low Voltage Differential Signalling (LVDS) interface standard, which uses very low voltage differences to define different logical states. Depending on the length of the transmission path, a data rates of several Gbits can be achieved.

An LVDS system consists of a digital driver, a receiver and the signal lines. The digital driver converts an external signal to an LVDS compliant signal and transmits it to the signal lines. The LVDS interface standard and most of the high-speed data transmission systems operate with low input voltages, such as 3.3V. Signal generators used to generate an input signal for a digital driver are often supplied with a voltage higher than the maximum ratings of the digital driver. In case of a malfunction of the signal generator, the high supply voltage could be applied to the low voltage inputs of the digital driver, destroy the digital driver and generate uncontrolled malfunction of other HW functional blocks. Over-voltage-protection-circuits can be used to prevent this.

Over-voltage-protection-circuits are commonly used in various types of circuit arrangements to protect a load against an over voltage injection normally caused by a malfunction of a power supply unit, a signal generator or any other component arranged between the load and the voltage supply. Over-voltage-protection-circuits often contain a large number of different components including semiconductor switches, comparator circuits and a voltage reference. For example, a typical over-voltage-protection-circuit contains two semiconductor switches, where one semiconductor switch, typically a Metal Oxide Semiconductor Field Effect Transistor (MOSFET), is connected directly in the power/signal line and is configured to control the current flow from the power supply to the load. The other semiconductor switch, typically a bipolar transistor, acts as a voltage detector and is configured to switch to a conductive state in the event of an over voltage injection, which further leads the MOSFET to throttle the current flow in the power/signal line, thereby protecting the load.

The main disadvantages of this type of over-voltage-protection-circuit are the direct influence of the MOSFET on the power/signal line even in a normal operating mode, i.e. no over voltage injection occurs, and the over-voltage protection in only one polarity. This type of over-voltage-protection-circuits only operates correctly if there is a positive over voltage injection, but not if there is a negative voltage injected.

In view of the foregoing, there is a need for a simple over-voltage-protection-circuit, in particular an over-voltage-protection-circuit which provides protection against a positive and negative over voltage injection and with little or no effect on the power/signal line in a normal operating mode.

In order to solve the above problem, an over-voltage-protection-circuit according to independent claim 1 is proposed.

According to an aspect of the invention an over-voltage-protection-circuit is provided.

The over-voltage-protection-circuit is configured to protect a high-speed digital signal driver against a positive and negative over voltage injection from an application hardware. The over-voltage-protection-circuit comprises a first semiconductor switch. The first semiconductor switch is configured to short a fault current in the event of an over voltage injection. The over-voltage-protection-circuit further comprises an input-circuit-element. The input-circuit-element is configured to reduce the fault current in the event of an over voltage injection. The over-voltage-protection-circuit further comprises a power supply. The power supply is connected to a control input of the first semiconductor switch. The power supply is configured to switch the first semiconductor switch in the event of an over voltage injection. The power supply is further configured to be inactive in a normal operating mode.

The first semiconductor switch may be connected on a transmission line on the one side and to the ground on the other side.

The transmission line may be the line that connects the application hardware output with the high-speed digital signal input.

The first semiconductor switch may be a bipolar transistor.

The first semiconductor switch may be in a forward-active mode in the event of a positive over voltage injection.

A bipolar transistor generally has three input ports, the base, the emitter and the collector port and consists of two opposing pn-junctions, comparable with two opposing diodes, a base-emitter diode and a base-collector diode. In a forward-active mode, the base-emitter diode is in a conductive state, wherein the base-collector diode, as it would be a single diode part, is in a non-conductive state. This allows a current, as it is the functionality of a NPN bipolar transistor, to pass through the bipolar transistor from the collector to the emitter, so that the bipolar transistor is in an on-state with low impedance similar to a short-circuit-element.

The first semiconductor switch may be in a clamping mode in the event of a negative over voltage injection.

In a clamping mode, when a negative over voltage injection is applied, the first semiconductor behaves like two opposing diodes, without the current amplification characteristics of the forward operation mode. Thus, in clamping mode the base-emitter diode and the base-collector diode are in a conductive state. This allows a current to pass through the bipolar transistor from the base to the collector and from the base to the emitter.

The first semiconductor switch may be in a blocking mode in the normal operating mode.

In a blocking mode, the base-emitter diode and the base-collector diode are in a nonconductive state. This allows no current pass through the first semiconductor switch.

The normal operating mode may be defined as a condition, where the application hardware works as intended, providing an input signal to the high-speed digital signal driver, and no positive or negative over voltage is injected. In the normal operating mode, only positive operational voltages are applied.

The collector port of the first semiconductor switch may be connected with the transmission line. The emitter port of the first semiconductor switch may be connected to the ground.

The first semiconductor switch may be connected to the transmission line on the one side at a specific position, so that it is connected between the input-circuit-element and the input of the high-speed digital signal driver.

The power supply may be a current source.

The current source may be connected to a control input of the first semiconductor switch on the one side and to the ground on the other side.

The control input may be the base port of the first semiconductor switch.

The current source may be activated in the event of an over voltage injection.

In the event of a positive and negative over voltage injection the current source may provide a control current to the base port of the first semiconductor switch.

The control current may be between 1mA and 500mA, for example 50mA.

The current source may be activated by an activation circuit.

The activation circuit may comprise a positive reference voltage, a negative reference voltage and a first and a second comparator circuit. The first comparator circuit may be configured to compare the voltage on the input-circuit-element with the positive reference voltage and to switch on the current source in case of a positive over voltage detection. The second comparator circuit may be configured to compare the voltage on the input-circuit-element with the negative reference voltage and to switch on the current source in case of a negative over voltage detection.

The input-circuit-element may be configured to provide a low impedance for highfrequency operations in the normal operating mode.

The input-circuit-element may be interconnected in the transmission line. The input-circuit-element may be connected with the application hardware on the one side and the high-speed digital signal driver on the other side.

The input-circuit-element may comprise a first resistor. The input-circuit element may further comprise a first capacitor. The first resistor and the first capacitor may be connected in parallel. The first resistor may have a value between 100Ω and 1000Ω, for example 520Ω. The first capacitor may have a value between 100pF and 10nF, for example 1nF.

The high-speed digital signal driver may be or comprise a Low Voltage Differential Signalling (LVDS) Driver. Low Voltage Differential Signalling in general is an interface standard for high-speed data transmission, that uses very low voltage differences to define different logical states. Depending on the length of the transmission path, data rates of several Gbits can be achieved.

The high-speed digital signal driver may have at least one signal line output.

The high-speed digital signal driver may have an external power supply

The application hardware may be or comprise a signal generator. The signal generator may be configured to provide a digital input signal for the high-speed digital signal driver. The signal generator may provide a pulsed input signal.

The pulsed input signal may have a signal level of 3,3V and a frequency of 100Mhz, wherein the pulsed input signal is a square wave signal.

The main advantage of the solution according to the invention as described above is that in the event of a malfunction of the application hardware or any additional component interconnected before the input of the over-voltage-protection-circuit, positive and negative over voltages do not apply to the input of the high-speed digital signal driver.

Other advantages are:
- no propagation of high voltage outside an electronic module.
- exceptionally low insertion capacitance.
- Simplicity of the over-voltage-protection-circuit due to a small number of standard parts required, therefore reducing costs.

In order to describe the manner in which the above and other advantages and features can be obtained, a more detailed description of the subject matter briefly described above will be rendered by reference to specific embodiments which are illustrated in the appended drawings. Understanding that these drawings depict only typical embodiments and are therefore not to be regarded as limiting in scope, embodiments will be described and explained with additional specificity and detail by use of the accompanying drawings in which:
**Fig. 1** illustrates an embodiment of the over-voltage-protection-circuit in the normal operating mode,
**Fig. 2** illustrates an embodiment of the over-voltage-protection-circuit in the event of a positive over voltage injection,
**Fig. 3** illustrates an embodiment of the over-voltage-protection-circuit in the event of negative over voltage injection.

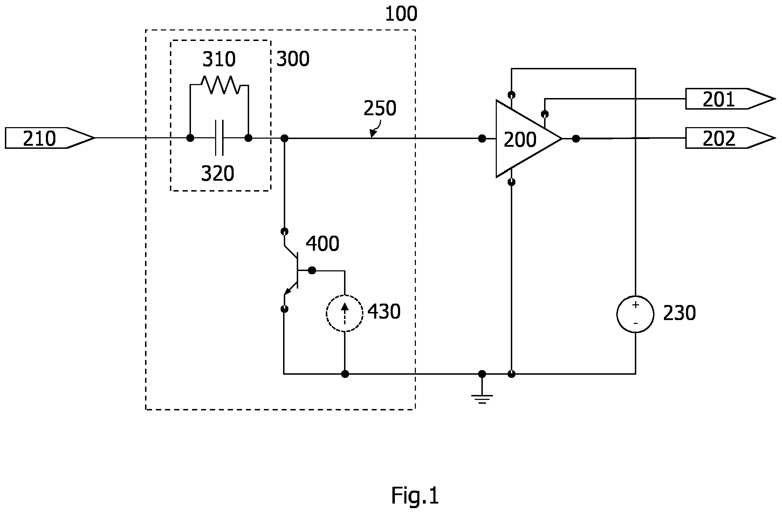

**Fig. 1** schematically shows an over-voltage-protection-circuit 100 that is interconnected between the application hardware 210 on the one side and the high-speed digital signal driver 200 on the other side, to protect the input of the high-speed digital signal driver 200 against an over voltage injection in the event of a malfunction of the application hardware 210.

The exemplary embodiment as shown in **Fig. 1** shows the over-voltage-protection-circuit in a normal operating mode in which the application hardware 210 works as intended, providing a digital input signal for the high-speed digital signal driver, and no positive or negative over voltage is injected.

The connection line between the application hardware 210 and the input of the high-speed digital signal driver 200 is also referred to as a transmission line 250.

The application hardware 210 in this exemplary embodiment is designed as a signal generator. In the normal operating mode, the signal generator provides a pulsed square wave signal with a frequency up to 655 MHz and a signal level of 3.3 V.

The high-speed digital signal driver 200 is designed as an LVDS-Driver according to the ANSI/TIA/EIA-644-A standard.

The high-speed digital signal driver 200 has an external power supply 230 providing a voltage of 3.3V, and two output high-speed signal lines 201/202.

The over-voltage-protection-circuit 100 has an input-circuit-element 300 interconnected in the transmission line 250, wherein the input-circuit-element 300 has a first resistor 310 and a first capacitor 320, and wherein the first resistor 310 and the first capacitor 320 are connected in parallel.

In general, the impedance of a capacitor depends on the frequency of the input signal and the capacitance of the capacitor. The higher the frequency and/or the capacitance, the lower the impedance of the capacitor. At high frequencies, a capacitor behaves almost like a short circuit.

The first capacitor 320 interconnected in the transmission line, has a high capacitance, for example 100pF, relative to the frequency of the input signal and the input capacitor 220 (6pF) of the high-speed digital signal driver 200. Therefore, the first capacitor 320 has little or no effect on the high frequency input signals provided by the application hardware 210 in a normal operating mode.

The over-voltage-protection-circuit 100 further has a first semiconductor switch 400. The first semiconductor switch 400 is connected to the transmission line 250 on the one side and to the ground on the other side. The first semiconductor switch 400 is connected to the transmission line 250 at a position between the input-circuit-element 300 and the high-speed digital signal driver 200, so that the input-circuit element 300 is arranged between the application hardware 210 and the first semiconductor switch 400.

In terms of circuitry, the first semiconductor switch 400 is connected in series with the input-circuit-element 300 and in parallel with the high-speed digital signal driver 200

The first semiconductor switch 400 as shown in this exemplary embodiment is a npn bipolar transistor. A npn bipolar transistor has three input ports, a base (B), an emitter (E) and a collector (C) port. A bipolar transistor has two opposing pn-junctions, comparable with two opposing diodes, a base-emitter diode and a base-collector diode. Both diodes can be in a conductive or a nonconductive state.

The base-emitter diode is controlled by an input current at the base port, while the state of the base-collector diode depends on the collector-emitter voltage applied from the outside.

The collector port of the first semiconductor switch 400 is connected to the transmission line at the above-mentioned position between the input-circuit-element 300 and the high-speed digital signal driver 200. The emitter port of the first semiconductor switch 400 is connected to the ground.

The over-voltage-protection circuit 100 further has a power supply 430 that is connected to the base port of the first semiconductor 400. In the exemplary embodiment as shown in **Fig. 1** the power supply 430 is a current source.

In the normal operating mode, the current source 430 is inactive (illustrated by the dotted lines), so that the base port is on the same potential (ground) as the emitter port of the first semiconductor 400. This results in the base-emitter diode being in a nonconductive state.

Since the base-emitter diode being in a non-conductive state, the first semiconductor switch 400 is in a blocking state, which does not allow current to pass through the first semiconductor switch 400.

All of the assumptions made in the description of the exemplary embodiment shown in **Fig. 1** also apply to all of the following descriptions for the sake of better understanding.

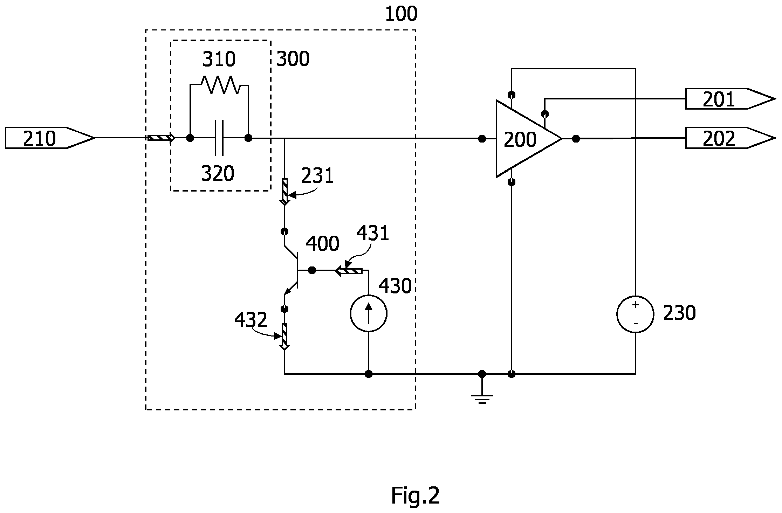

**Fig. 2** schematically shows an over-voltage-protection-circuit 100 interconnected between the application hardware 210 on the one side and the high-speed digital signal driver 200 on the other side, wherein the application hardware 210 has a malfunction and a positive over voltage is injected into the over-voltage-protection circuit 100.

The structural design of the over-voltage-protection-circuit 100 and the peripheral components, such as the application hardware 210 and the high-speed digital signal driver 200 corresponds to the structural design of the exemplary embodiment as shown in Fig.1 and will not be explained in detail again.

The application hardware 210 has an external power supply for powering the signal generator, which supplies a direct current (DC) voltage of, for example, +13V. The external power supply is not explicitly shown in Fig. 2.

In this exemplary embodiment the application hardware 210 has a malfunction and now the external power supply voltage, referred to as positive fault DC voltage in the following, with a signal level of +13V, instead of the square wave signal with a frequency up to 655 Mhz and a signal level of for example +3.3V, is applied to the output of the application hardware 210 and therefore injected into the over-voltage-protection-circuit 100.

In the event of an over voltage injection into the over-voltage-protection-circuit 100 the power supply 430 is activated. The power supply 430 is a current source in the exemplary embodiment and is no longer inactive, but provides a control current 431 to the base port of the first semiconductor switch 400.

An additional activation circuit, not explicitly shown in Fig. 2, is used to activate the power supply 430. The activation circuit comprises a positive reference voltage, a negative reference voltage and a first and a second comparator circuit. The first comparator circuit compares the voltage on the input-circuit-element with the positive reference voltage and switches on the current source in case of a positive over voltage detection. The second comparator circuit compares the voltage on the input-circuit-element with the negative reference voltage and switches on the current source in case of a negative over voltage detection.

The control current 431 now flowing in the base port of the first semiconductor switch 400 causes the base-emitter diode of the first semiconductor switch 400 to be set to a conductive state. For example, the control current 431 has a value of 50mA. The direction of flow of the control current 431 is indicated by the hatched arrow.

The positive fault DC voltage of the malfunctioned application hardware 210 maintains the base-collector diode of the first semiconductor switch 400 to be set in a nonconductive state.

The first semiconductor switch 400, with the base-emitter diode in a conductive state and the base-collector diode in a nonconductive state, is in a forward-active mode allowing a current to pass through the first semiconductor switch 400 from the collector port to the emitter port. The first semiconductor switch 400 has a low impedance similar to a short-circuit element and therefore short-circuits the transmission line 220 at the position between the input-circuit-element 300 and the input of the high-speed digital signal driver 200, so that the input of the high-speed digital signal driver 200 is also short-circuited and no voltage is applied to the input of the high-speed digital signal driver 200.

With the first semiconductor switch 400 in the forward-active mode, the entire positive fault DC voltage is applied to the input-circuit-element 300. Due to the positive fault DC voltage, the first capacitor 320 acts as an open circuit and has no effect on the over-voltage-protection-circuit 100. Therefore, the entire positive fault DC voltage is applied to the first resistor 310. The value of the first resistor 310 in conjunction with the positive fault DC voltage determines the current intensity of the fault current 231. The first resistor 310 is used to limit the fault collector current 231, so that the first semiconductor 400 switch does not break down.

In this exemplary embodiment the value of the first resistor 310 is 520Ω, resulting in a fault current 231 of 25mA.

The fault current 231 passes through the first semiconductor switch 400, which is in a forward-active mode, and flows out of the emitter port as the emitter current 432.

The emitter current 432 is the combination of the control current 431, provided by the power supply 430 to switch the first semiconductor switch 400, and the fault current 231 and therefore, in this particular exemplary embodiment has a value of 75mA.

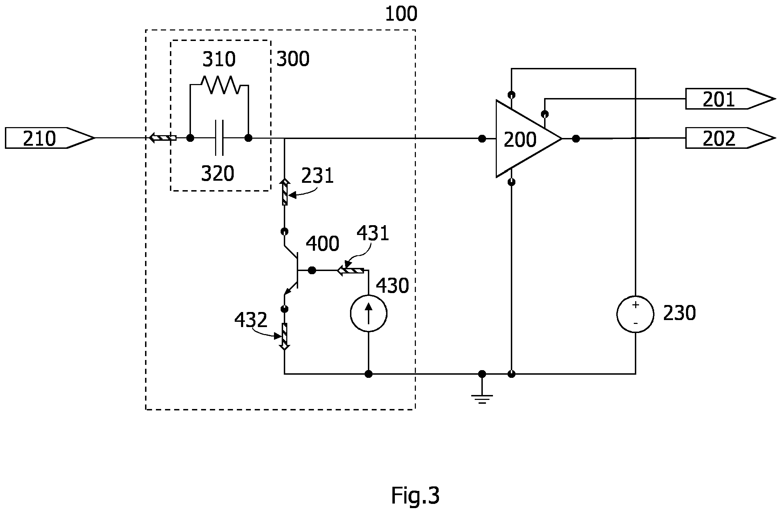

**Fig. 3** schematically shows an over-voltage-protection-circuit 100 interconnected between the application hardware 210 on the one side and the high-speed digital signal driver 200 on the other side, wherein the application hardware 210 has a malfunction and a negative over voltage is injected into the over-voltage-protection circuit 100.

The structural design of the over-voltage-protection-circuit 100 and the peripheral components, such as the application hardware 210 and the high-speed digital signal driver 200 corresponds to the structural design of the exemplary embodiment as shown in **Fig.1** and will not be explained in detail again.

The application hardware 210 as shown in the exemplary embodiment in **Fig. 3** has a malfunction and now supplies a negative fault DC voltage with a signal level of - 13V instead of the square wave signal with a frequency up to 655Mhz and a signal level of +3.3V.

In the event of an over voltage injection into the over-voltage-protection-circuit 100 the power supply 430 is activated. The power supply 430, a current source in this exemplary embodiment, is no longer inactive, but provides a control current 431 to the base port of the first semiconductor switch 400.

An additional activation circuit, not shown here, is used to activate the power supply 430 in the event of an over voltage injection. The activation circuit comprises a positive reference voltage, a negative reference voltage and a first and a second comparator circuit. The first comparator circuit compares the voltage on the input-circuit-element with the positive reference voltage and switches on the current source in case of a positive over voltage detection. The second comparator circuit compares the voltage on the input-circuit-element with the negative reference voltage and switches on the current source in case of a negative over voltage detection.

In the event of a negative over voltage injection, the first semiconductor switch 400 behaves like two opposing diodes without the current amplification characteristics, as in the forward operation mode. In the so-called clamping mode, the base-emitter diode and the base-collector diode are in a conductive state. This allows a current pass through the bipolar transistor from the base port to the collector port and from base port to the emitter port. A current flow from the collector port to the emitter port or vice versa is not possible.

In clamping mode, the first semiconductor switch 400 clamps the negative fault DC voltage applied on the high-speed digital signal driver 200 to nearly 0V against ground reference. This requires the entire negative fault DC voltage to be applied to the input-circuit-element 300. In this exemplary embodiment, the first resistor 310 of the input-circuit-element 300 has a value of 520Ω, resulting in a necessary fault current 231 of 25mA required for the entire negative fault DC voltage to be applied to the input-circuit-element 300.

Since the first semiconductor switch 400 acts like two opposite diodes in clamping mode and current can only flow from the base port to the collector port or from the base port to the emitter port, the control current 431 must be at least as high as the required fault current 231.

In this example, the control current 431 has a value of 50mA. The direction of flow of the control current 431 is indicated by the hatched arrow.

The first semiconductor switch 400 in clamping mode short-circuits the transmission line 220 at the position between the input-circuit-element 300 and the high-speed digital signal driver 200, via the current flow from the base port to the collector port of the first semiconductor switch 400. Therefore, even in the event of a negative over voltage injection, the input of the high-speed digital signal driver 200 is short-circuited and no voltage is applied to the input of the high-speed digital signal driver 200.

With the first semiconductor switch 400 in clamping mode, the entire negative fault DC voltage is applied to the input-circuit-element 300. Due to the negative fault DC voltage, the first capacitor 320 acts as an open circuit and has no effect on the over-voltage-protection-circuit. Therefore, the entire negative fault DC voltage is applied to the first resistor 320. The value of the first resistor 310 therefore determines the level of the fault current 231 required for the entire negative fault DC voltage to be applied to the first resistor 310, but also limits the maximum level of the fault current 231 so that the first semiconductor switch 400 is not damaged.

In the event of a negative fault DC voltage injection as shown in this exemplary embodiment, the direction of flow of the fault current 231 is opposite to the direction of flow as in the event of a positive fault DC voltage injection. In particular, this means that the fault current 231 flows from the collector port of the first semiconductor switch 400 to the application hardware 210.

With the first semiconductor switch 400 in clamping mode a current flow is only possible from the base port to the emitter port and from the base port to the collector port. The control current 431 in this exemplary embodiment is 50mA. Due to the fault current 231 is limited to 25mA, the control current 431 is divided in a current flow from the base port to the emitter port and to the collector port, so that the emitter current 432 is also 25mA in this case.

The direction of flow of each of the control current 431, the emitter current 432 and the fault current 231 is indicated by the hatched arrows.

The variations of the apparatus described above, their structural and operational aspects, and the variations of the method are intended only to provide a better understanding of the structure, operation and properties and do not limit the disclosure to the embodiments. The figures are partly schematic. Essential features and effects are shown, in some cases clearly enlarged, in order to clarify the functions, operating principles, technical embodiments and features. Each mode of operation, each principle, each technical embodiment and each feature disclosed in the figures or in the text can be freely and arbitrarily combined with all claims, each feature in the text and in the other figures, other modes of operation, principles, technical embodiments and features contained in this disclosure or resulting therefrom, so that all conceivable combinations can be assigned to the described procedure. This includes combinations between all individual embodiments in the text, i.e. in each section of the description, in the claims and also combinations between different variants in the text, in the claims and in the figures. Nor do the claims limit the disclosure and thus the possible combinations of all disclosed features. All disclosed features are also explicitly disclosed here, individually and in combination with all other features.

## Claims

1. An over-voltage-protection-circuit (100) that is configured to protect a high-speed digital signal driver (200) against a positive and negative over voltage injection from an application hardware (210), wherein the over-voltage-protection-circuit (100) comprises:
i) a first semiconductor switch (400) that is configured to short a fault current (231) in the event of an over voltage injection;
ii) an input-circuit-element (300) that is configured to reduce the fault current (231) in the event of an over voltage injection;
iii) a power supply (430) that is connected to a control input of the first semiconductor switch and that is configured to switch the first semiconductor switch (400) in the event of an over voltage injection and to be inactive in a normal operating mode.

2. The over-voltage-protection-circuit (100) according to claim 1, wherein the input-circuit-element (300) is configured to provide a low impedance for highfrequency operations in the normal operating mode.

3. The over-voltage-protection-circuit (100) according to claim 1 or 2, wherein the first semiconductor switch (400) is a bipolar transistor.

4. The over-voltage-protection-circuit (100) according to claim 3, wherein the first semiconductor switch (400) is in a forward-active mode in the event of a positive over voltage injection.

5. The over-voltage-protection-circuit (100) according to claim 3 or 4, wherein the first semiconductor switch (400) is in a clamping mode in the event of a negative over voltage injection.

6. The over-voltage-protection-circuit (100) according to claims 3 to 5, wherein the first semiconductor switch (400) is in a blocking mode in the normal operating mode.

7. The over-voltage-protection-circuit (100) according to any of the previous claims, wherein the power supply (430) is a current source.

8. The over-voltage-protection-circuit (100) according to claim 7, wherein the power supply (430) provides a control current (431) in the event of a positive and negative over voltage injection.

9. The over-voltage-protection-circuit (100) according to any of the previous claims, wherein the input-circuit-element (300) comprises a first resistor (310) and a first capacitor (320) that are connected in parallel.

10. The over-voltage-protection-circuit (100) according to claim 9, wherein the first resistor (310) has a value between 100Ω and 1000Ω, for example 520Ω.

11. The over-voltage-protection-circuit (100) according to claim 9 or 10, wherein the first capacitor (320) has a value between 100pF and 10nF, for example 1nF.

12. The over-voltage-protection-circuit (100) according to any of the previous claims, wherein the high-speed digital signal driver (200) is a Low Voltage Differential Signalling (LVDS) Driver.

13. The over-voltage-protection-circuit (100) according to any of the previous claims, wherein the application hardware (210) comprises a signal generator that is configured to provide digital input signals for the high-speed digital signal driver (210).

## Amended claims

### Amended claims in accordance with Rule 137(2) EPC.

1. An over-voltage-protection-circuit (100) that is configured to protect a high-speed digital signal driver (200) against a positive and negative over voltage injection from an application hardware (210), wherein the output of the application hardware (210) is connected with the input of the high-speed digital signal driver (200) via a transmission line (250), and wherein the over-voltage-protection-circuit (100) comprises:
i) a first semiconductor switch (400) that is configured to short a fault current (231) in the event of an over voltage injection, wherein the first semiconductor switch (400) is connected to the transmission line (250) on the one side and to the ground on the other side;
ii) an input-circuit-element (300) that is configured to reduce the fault current (231) in the event of an over voltage injection;
iii) a power supply (430) that is connected to a control input of the first semiconductor switch and that is configured to switch the first semiconductor switch (400) in the event of an over voltage injection and to be inactive in a normal operating mode.

2. The over-voltage-protection-circuit (100) according to claim 1, wherein the input-circuit-element (300) is configured to provide a low impedance for highfrequency operations in the normal operating mode.

3. The over-voltage-protection-circuit (100) according to claim 1 or 2, wherein the first semiconductor switch (400) is a bipolar transistor.

4. The over-voltage-protection-circuit (100) according to claim 3, wherein the first semiconductor switch (400) is in a forward-active mode in the event of a positive over voltage injection.

5. The over-voltage-protection-circuit (100) according to claim 3 or 4, wherein the first semiconductor switch (400) is in a clamping mode in the event of a negative over voltage injection.

6. The over-voltage-protection-circuit (100) according to claims 3 to 5, wherein the first semiconductor switch (400) is in a blocking mode in the normal operating mode.

7. The over-voltage-protection-circuit (100) according to any of the previous claims, wherein the power supply (430) is a current source.

8. The over-voltage-protection-circuit (100) according to claim 7, wherein the power supply (430) provides a control current (431) in the event of a positive and negative over voltage injection.

9. The over-voltage-protection-circuit (100) according to any of the previous claims, wherein the input-circuit-element (300) comprises a first resistor (310) and a first capacitor (320) that are connected in parallel.

10. The over-voltage-protection-circuit (100) according to claim 9, wherein the first resistor (310) has a value between 100Ω and 1000Ω, for example 520Ω.

11. The over-voltage-protection-circuit (100) according to claim 9 or 10, wherein the first capacitor (320) has a value between 100pF and 10nF, for example 1nF.

12. The over-voltage-protection-circuit (100) according to any of the previous claims, wherein the high-speed digital signal driver (200) is a Low Voltage Differential Signalling (LVDS) Driver.

13. The over-voltage-protection-circuit (100) according to any of the previous claims, wherein the application hardware (210) comprises a signal generator that is configured to provide digital input signals for the high-speed digital signal driver (210).
